(19) **Europäisches Patentamt / European Patent Office / Office européen des brevets**

(11) **EP 2 439 544 B1**

(12) **EUROPEAN PATENT SPECIFICATION**

(45) Date of publication and mention of the grant of the patent:
**28.10.2015 Bulletin 2015/44**

(21) Application number: **10197125.7**

(22) Date of filing: **28.12.2010**

(51) Int Cl.:
*G01R 15/20* (2006.01)  *G01R 15/14* (2006.01)

(54) **MEMS current sensing apparatus**

MEMS-Stromerfassungsvorrichtung

Appareil de détection de courant MEMS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.10.2010 TW 099133961**

(43) Date of publication of application:
**11.04.2012 Bulletin 2012/15**

(73) Proprietor: **Industrial Technology Research Institute**
**Chu-Tung, Hsin-Chu (TW)**

(72) Inventors:
• **Cheng, Shih-Hsien**
**80784 Kaohsiung City (TW)**
• **Ho, Wu-Chi**
**300 Hsinchu City (TW)**
• **Lin, Cheng-Ting**
**32059 Jhongli City, Taoyuan County (TW)**
• **Cheng, Yu-Ting**
**23455 Yonghe City, Taipei County (TW)**
• **Liang, Pei-Fang**
**31055 Zhudong Township, Hsincu County (TW)**

• **Chen, Yung-Chang**
**50053 Changhua City, Changhua County (TW)**

(74) Representative: **Lang, Christian et al**
**LangPatent**
**Anwaltskanzlei**
**Rosenheimer Strasse 139**
**81671 München (DE)**

(56) References cited:
**US-A- 5 617 020**

• **Eli S. Leland ET AL: "Electric Power Sensing for Demand Response", , 6 April 2010 (2010-04-06), pages 1-14, XP055050228, Retrieved from the Internet: URL:http://uc-ciee.org/downloads/leland-cu rrent_sensor-DR-TAC_and_CEC_2010-04-06.pdf [retrieved on 2013-01-18]**
• **WHITE R: "Demand Response: Passive Proximity Electric Sensing", INTERNET CITATION, 10 June 2004 (2004-06-10), XP002372121, Retrieved from the Internet: URL:http://www.ucop.edu/ciee/dretd/white%2 0june%2010,%202004%20final.pdf [retrieved on 2006-03-15]**

**Description**

**TECHNICAL FIELD**

The present disclosure relates to a current sensing apparatus, and more particularly, to a micro-electro-mechanical system (MEMS) current sensing apparatus based on the Faraday's law of induction.

**TECHNICAL BACKGROUND**

The usage of energy is generally represented in units of energy (Joule) or power (Watt). To measure the energy usage or dissipation in a circuit, the electrical voltage or current is detected in a variety of measuring or sensing devices and methods. In order to save the energy consumption or to diminish the energy waste, it is of value to combine the information of energy usage with the communication technology of presence, so as to provide energy users with the related information for energy management of more efficiency.

However, applicability of the traditional current sensors for measuring the energy usage of electricity have been limited, due to some demerits such as large size, external electric source needed, and incapability of applying to the electrical wires of multiple conductors. Some have proposed MEMS current sensors based on the law of Lorentz force to measure a flowing current according to the mechanical deviation by the current-induced electromagnetic field, leading the foregoing drawbacks to be alleviated. Examples for sensors based on the law of Lorentz force are discussed by E.S. Leland in "Electric Power Sensing for Demand Response" (6 April 2010, p. 1 to 14, XP055050228), by R. White in "Demand Response: Passive Proximity Electric Sensing" (10 June 2004, XP002372121) and in US 5,617,020 A. Nevertheless, their performance can not satisfy potential requirements in the residence or the industry. Therefore, it is in need of a current sensor of compactness, non-contact, passiveness, and friendly utility for enabling a user to obtain sufficient information of energy usage to manage and thus save the energy.

**TECHNICAL SUMMARY**

The above mentioned object is solved by the micro-electro-mechanical system (MEMS) current sensing apparatus according to claim 1. Advantageous improvements are described by dependant claims. According to one aspect of the present disclosure, one embodiment provides an MEMS-based current sensing apparatus including: a flexible substrate joined onto an conducting wire; a sensing unit formed of an MEMS structure and disposed on the flexible substrate, the sensing unit outputting a response to a electromagnetic field induced by a current flowing in the conducting wire; and a readout circuit disposed on the flexible substrate and coupled to the sensing unit, the readout circuit monitoring the response to the electromagnetic field and calculating the amount of the current flow. Furthermore, the sensing unit may comprise a conductor coil having a material of magnetic permeability therein, and having its linewidth parallel with the conducting wire larger than its linewidth perpendicular to the conducting wire.

Further scope of applicability of the present application will become more apparent from the detailed description given hereinafter. However, it should be understood that the detailed description and specific examples, while indicating exemplary embodiments of the disclosure, are given by way of illustration only, since various changes and modifications within the spirit and scope of the disclosure will become apparent to those skilled in the art from this detailed description.

**BRIEF DESCRIPTION OF THE DRAWINGS**

The present disclosure will become more fully understood from the detailed description given herein below and the accompanying drawings which are given by way of illustration only, and thus are not limitative of the present disclosure and wherein:

FIG. 1 is a schematic diagram showing the architecture of an MEMS current sensing apparatus according to an embodiment of the present disclosure.

FIG. 2 is a side-view diagram showing the architecture of an MEMS current sensing apparatus according to an embodiment of the present disclosure.

FIG. 3 is a schematic architecture of an MEMS current sensing apparatus with a C-shaped clamp according to another embodiment of the present disclosure.

**DESCRIPTION OF THE EXEMPLARY EMBODIMENTS**

For further understanding and recognizing the fulfilled functions and structural characteristics of the disclosure, several exemplary embodiments cooperating with detailed description are presented as the following.

According to the Ampere's law, when an electrical current flowing in a long conducting line, a magnetic field is induced in the neighborhood of the conducting line. The intensity of the magnetic field $B_r$ at a distance of r from the conducting line is proportional to the current

flow: $B_r = \dfrac{\mu_0 I}{2\pi r}$, wherein $\mu_0$ denotes magnetic con-

stant, and I denotes the magnitude of the flowing current. With regards to a conducting coil adjacent to the conducting line, the Faraday's law of induction predicts an electromotive force (EMF) of the coil in volts as

$$EMF(v) = -\frac{d\phi}{dt} = -\int \frac{d\left(\overrightarrow{Br} \bullet \overrightarrow{A}\right)}{dt},$$ wherein $\phi$ de-

notes the magnetic flux in wabers, $\overline{A}$ denotes the surface vector of the conducting coil, and the direction of the electromotive force is given by the Lenz's law. It can be derived from the above equation that proportion relationship of the electromotive force satisfies $EMF(v) \propto \phi \propto \overline{Br \cdot A} \propto I$ to be designed as a current sensor.

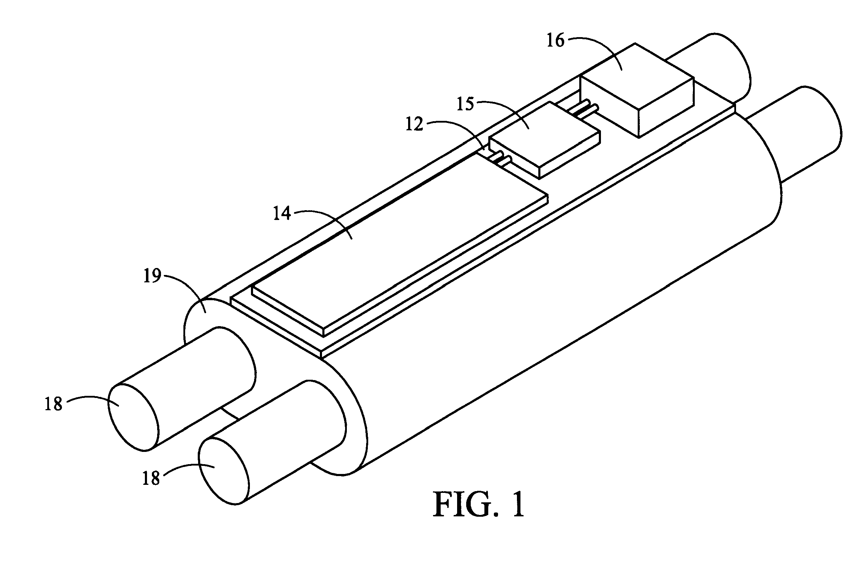

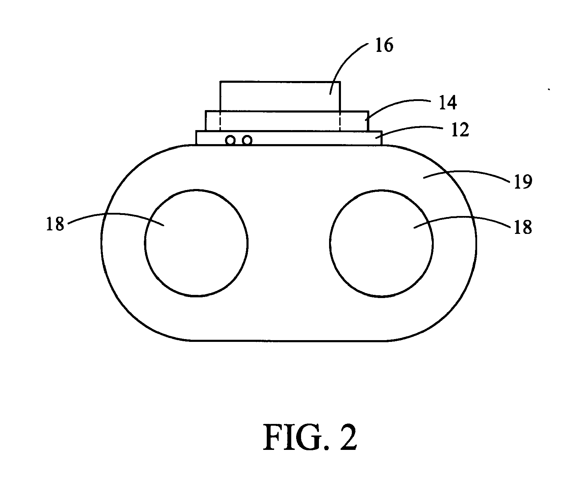

Please refer to FIGS. 1 and 2, which are schematic diagrams showing the architecture of an MEMS current sensing apparatus according to an embodiment of the present disclosure, FIG. 1 is its three-dimensional projective diagram and FIG. 2 is its corresponding side-view diagram. The embodiment includes: a flexible substrate 12, a sensing unit 14, an amplifier 15, and a readout circuit 16. Integration of all components of the embodiment can be designed and fabricated by the MEMS process, and flexibility of the flexible substrate 12 may facilitate convenience and achievability of a current sensor of compact size, non-contact, and passiveness.

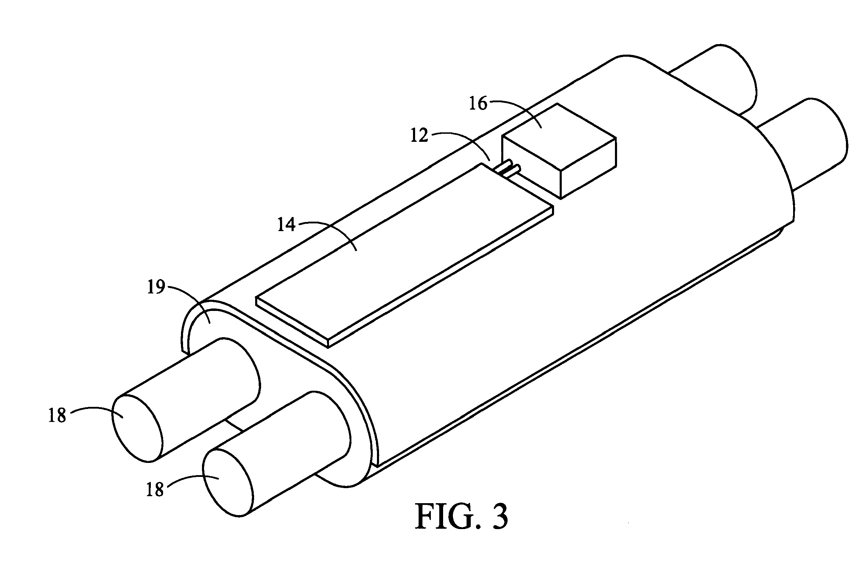

The lower surface of the flexible substrate 12 can be attached directly or indirectly onto a conducting wire 18 or a conductor covered in a protective jacket 19 of plastic, while the upper surface is used to dispose or form a sensing device and its circuit thereon. The flexible substrate 12 is formed of elastic material to attach to the conducting wire tightly; whereby the sensing unit 14 can get closer to the conducting wire 18 to gain a better effect of electromagnetic inductance. Due to the elastic and flexible features of the substrate 12, the current sensing apparatus of the embodiment is of convenience of "stick-and-play", and is of tolerance to roughness and shapes of the conducting wire to be measured. Besides, the flexible substrate 12 may also be formed of C-shaped clamp, to clamp the protective jacket 19 of the conducting wire 18 directly, as shown in FIG. 3.

The sensing unit 14 is formed of an MEMS structure by the MEMS process and disposed on the flexible substrate 12, to measure the electromagnetic field induced by the current flowing in the conducting wire 18 and output a response corresponding to the electromagnetic field. The sensing unit 14 is composed of a conductor coil or a tightly-wound wire coil of at least one identical loop. For example, a copper coil with one loop is used as the sensing unit 14 in this embodiment, but is not limited thereby; it can be formed of another metal, or configured of coil of multiple loops to possibly increase the magnitude of electromagnetic induction. To further intensify the effect of magnetic permeability, a material of high magnetic permeability can be added in and covered in the conductor coil itself; moreover in an exemplary embodiment, the conductor coil may be patterned so that the linewidth parallel with the conducting wire 18 is larger than its linewidth perpendicular to the conducting wire 18.

The readout circuit 16 is disposed on the flexible substrate and coupled to the sensing unit 14 to monitor the response to the electromagnetic field induced by current flowing in the conducting wire 18 and calculating the amount of the current in the conducting wire 18. The readout circuit 16 may be fabricated by the process of complementary metal-oxide-semiconductor integrated circuits (CMOS-IC). The response from the sensing unit 14 may be of different form of energy parameter to be calculated or be too weak to be read by the readout circuit 16. Therefore, the amplifier 15 may be integrated into the readout circuit 16 to transduce or amplify the response of the sensing unit 14, but is not limited thereby; the amplifier 15 can be a discrete chip disposed on the flexible substrate 12 and coupled to the sensing unit and the readout circuit. In the embodiment, the amplifier 15 functions to transduce the response of current of the sensing unit 14 to a voltage or amplify the response of voltage to a current.

It should be noted, in this embodiment, the conductor coil is schemed according to the Faraday's law of induction and fabricated by the MEMS process to achieve compactness and integration of a passive current sensor. Another feature of the embodiment is the exploitation of the flexible substrate, so as to achieve a non-contact current sensor with ease to setup and use.

With respect to the above description then, it is to be realized that the optimum dimensional relationships for the parts of the disclosure, to include variations in size, materials, shape, form, function and manner of operation, assembly and use, are deemed readily apparent and obvious to one skilled in the art, and all equivalent relationships to those illustrated in the drawings and described in the specification are intended to be encompassed by the present disclosure.

**Claims**

1. A micro-electromechanical system (MEMS) current sensing apparatus comprising:

   a flexible substrate (12) joinable onto a conducting wire (18);
   a sensing unit (14) comprising a conductor coil forming an inductor, formed of an MEMS structure and disposed on the flexible substrate (12), the sensing unit (14) directly detecting an electromagnetic field induced by a current flowing in the conducting wire (18) according to Faraday's law of induction and outputting a response to an electromagnetic field induced by a current flowing in the conducting wire (18); and
   a readout circuit (16) disposed on the flexible substrate (12) and coupled to the sensing unit (14), the readout circuit (16) monitoring the response to the electromagnetic field and calculating the amount of the current.

2. The apparatus of claim 1, wherein the conducting wire is covered in a protective jacket (19) of plastic.

3. The apparatus of claim 1, further comprising:

   at least one amplifier (15) coupled to the sensing unit (14) and the readout circuit (16), the at least one amplifier transducing or amplifying the response of the sensing unit (14).

4. The apparatus of claim 1, wherein the flexible substrate (12) is formed of elastic material to attach to the conducting wire (18) tightly.

5. The apparatus of claim 1, wherein the conductor coil is formed of metal and has at least one turn.

6. The apparatus of claim 1, wherein the conductor coil further comprises:

   a material of magnetic permeability covered in the conductor coil itself.

7. The apparatus of claim 1, wherein the metal coil has its linewidth parallel with the conducting wire larger than its linewidth perpendicular to the conducting wire.

8. The apparatus of claim 1, wherein the readout circuit (16) is formed by the process of complementary metal-oxide-semiconductor (CMOS) integrated circuits, and is coupled to the sensing unit (14).


**Patentansprüche**

1. Stromerfassungsvorrichtung eines mikro-elektro-mechanischen System (MEMS), umfassend:

   ein flexibles Substrat (12), das an einem Leiterdraht (18) angebracht werden kann,
   eine Erfassungseinheit (14) mit einer eine Induktivität bildende Leiterspule, welche aus einer MEMS - Struktur hergestellt ist und an dem flexiblen Substrat (12) angeordnet ist, wobei die Erfassungseinheit (14) ein elektromagnetisches Feld, das durch einen durch den Leiterdraht (18) fließenden Strom gemäß dem Faraday's Induktionsgesetz induziert wird, direkt erfasst und eine Antwort entsprechend einem elektromagnetischen Feld, das durch einen durch den Leiterdraht (18) fließenden Strom induziert wird, ausgibt, und
   eine Ausleseschaltung (16), die an dem flexiblen Substrat (12) angeordnet ist und mit der Erfassungseinheit (14) verbunden ist, wobei die Ausleseschaltung (16) die Antwort auf das elektromagnetische Feld überwacht und die Stromstärke berechnet.

2. Vorrichtung nach Anspruch 1, bei welcher der Leitungsdraht von einem Schutzmantel (19) aus Kunststoff umgeben ist.

3. Vorrichtung nach Anspruch 1, welche ferner

wenigstens einen Verstärker (15) umfasst, der mit der Erfassungseinheit (14) und der Ausleseschaltung (16) verbunden ist, wobei der wenigstens eine Verstärker die Antwort der Erfassungseinheit (14) umwandelt oder verstärkt.

4. Vorrichtung nach Anspruch 1, bei welcher das flexible Substrat (12) aus einem elastischen Material gebildet ist, um fest an dem Leiterdraht (18) befestigt zu werden.

5. Vorrichtung nach Anspruch 1, bei welcher die Leiterspule aus Metall gebildet ist und wenigstens eine Windung hat.

6. Vorrichtung nach Anspruch 1, bei welcher die Leiterspule ferner ein Material mit magnetischer Permeabilität umfasst, das in der Leiterspule selbst enthalten ist.

7. Vorrichtung nach Anspruch 1, bei welcher die Linienbreite der Metallspule parallel zum Leiterdraht größer ist als deren Linienbreite senkrecht zum Leiterdraht.

8. Vorrichtung nach Anspruch 1, bei welcher die Ausleseschaltung (16) durch das Verfahren für integrierte Schaltungen der komplementären Metalloxid-Halbleitertechnologie (CMOS) hergestellt ist und mit der Erfassungseinheit (14) verbunden ist.


**Revendications**

1. Appareil de détection de courant de microsystème électromécanique (MEMS) comprenant :

   un substrat flexible (12) qui peut être assemblé sur un fil conducteur (18) ;
   une unité de détection (14) comprenant une bobine conductrice formant une inductance, formée d'une structure MEMS et disposée sur le substrat flexible (12), l'unité de détection (14) détectant directement un champ électromagnétique induit par un courant circulant dans le fil conducteur (18) selon la loi de Faraday de l'induction et émettant une réponse à un champ électromagnétique induit par un courant circulant dans le fil conducteur (18) ; et
   un circuit de lecture (16) disposé sur le substrat flexible (12) et couplé à l'unité de détection (14), le circuit de lecture (16) surveillant la réponse au champ électromagnétique et calculant la quantité de courant.

2. Appareil selon la revendication 1, dans lequel le fil conducteur est recouvert dans une gaine de protection (19) en plastique.

3. Appareil selon la revendication 1, comprenant en outre :

> au moins un amplificateur (15) couplé à l'unité de détection (14) et au circuit de lecture (16), l'au moins un amplificateur transmettant ou amplifiant la réponse de l'unité de détection (14).

4. Appareil selon la revendication 1, dans lequel le substrat flexible (12) est formé d'un matériau élastique pour une fixation étroite au fil conducteur (18).

5. Appareil selon la revendication 1, dans lequel la bobine conductrice est formée de métal et présente au moins un tour.

6. Appareil selon la revendication 1, dans lequel la bobine conductrice comprend en outre :

> un matériau de perméabilité magnétique recouvert dans la bobine conductrice elle-même.

7. Appareil selon la revendication 1, dans lequel la bobine en métal a sa largeur de ligne parallèle au fil conducteur qui est supérieure à sa largeur de ligne perpendiculaire au fil conducteur.

8. Appareil selon la revendication 1, dans lequel le circuit de lecture (16) est formé par le processus de circuits intégrés à semi-conducteurs à oxyde de métal (CMOS) complémentaires, et est couplé à l'unité de détection (14).

FIG. 1

FIG. 2

EP 2 439 544 B1

FIG. 3

**EP 2 439 544 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5617020 A

**Non-patent literature cited in the description**

- **E.S. LELAND ; R. WHITE.** Electric Power Sensing for Demand Response. *Demand Response: Passive Proximity Electric Sensing,* 10 April 2004, 1-14